# EUROPEAN PATENT SPECIFICATION

(11) **EP 1 897 465 B1**
(45) Date of publication and mention of the grant of the patent: **25.02.2009**
(21) Application number: 07113997.6
(22) Date of filing: 08.08.2007
(51) Int. Cl.: A47B 47/00, A47B 47/03, A47B 47/02

(54) **Manufacturing method for metal cabinets**
Herstellungsverfahren für Metallschränke
Procédé de fabrication pour armoires métalliques

(30) Priority: 04.09.2006 IT PN20060066
(43) Date of publication of application: 12.03.2008
(73) Proprietor: Hager-Lumetal S.p.A., 33080 Porcia, Pordenone (IT)
(72) Inventor: Castria, Franco, 33080, Prata (Pordenone) (IT); Dal Santo, Roberto, 33080, Roveredo in Piano (Pordenone) (IT)
(74) Representative: Gonella, Mario

(56) References cited:
- EP-A- 0 147 022
- GB-A- 1 512 899

## Description

The present invention refers to an improved method for manufacturing metal cabinets, in particular cabinets adapted to house electric and similar apparatus.

Metal cabinets or enclosures of the above-indicated kind are usually comprised of a structural framework and covering panels, as well as at least one closing door. The structural framework is in turn comprised of bar members, the end portions of which are releasably connected with each other by means of fastening members and screw members. This generally known method, however, has a number of drawbacks.

In the first place, a quite large number of parts are required, in particular screws and bolts, which are rather difficult to both insert in the desired position and tighten in a satisfactory manner, so as to ensure the required structural strength and stability of the framework. In addition, particularly in the case of thee-dimensional connections, i.e. when three bar members have to be joined at a right angle to each other, the fastening members have to be mounted with the use of proper tools. For these reasons, the overall time required to manufacture cabinets of this kind is rather long, thereby affecting the final overall cost of the product to a really considerable extent.

Described in patent publication GB 1.512.899 is an improved manufacturing method aimed at reducing the cabinet assembly difficulties, avoiding any loss of parts, and ensuring a satisfactory end result in terms of structural strength and solidity of the metal cabinets in the assembled state thereof. The method described in this patent publication, however, is based on the use of split-ring tubular bar members, i.e. bar members having an open tubular cross-sectional shape, which are connected to each other with the aid of cube-shaped angle members that are provided on three adjacent faces thereof with plugs adapted to fit into the respective extremities of the split-ring tubular bar members. At each such extremity of the split-ring tubular bar members there are provided, by notching, punching or similar metal-forming method, obliquely extending recesses, at the bottom of which there are provided threaded bores. The fastening screws are then inserted in the holes provided in the tubular bar members in an inclined position to engage corresponding ones of said threaded bores provided in the angle members used as connection means. This method is not effective in doing totally away with the drawbacks that are generally encountered in the afore-cited prior-art methods, since it still has part of them. In particular, it requires a multiplicity of screws to be used for connecting each extremity of each tubular bar member forming the cabinet framework, owing also to the fact that such tubular bar members of the framework have a split-ring cross-sectional shape, i.e. they are split or open longitudinally, so that the need arises for both edges thereof to be screwed on in order to prevent the same tubular bar members from opening out when strained during tightening. For this reason, the system turns therefore out as being still rather complicated and time-consuming to implement.

It therefore is a main object of the present invention to provide a metal cabinet for electrical apparatus, which is simpler and quicker to manufacture than prior-art cabinets of the same kind in general, through the use of closed-section profile bar members and a reduced number of fastening members for the support framework, while still ensuring a maximum extent of structural strength and stability.

Another major purpose of the present invention is to provide an improved system for the connection of the various structural parts with each other, so as to carry out a kind of pre-assembly at the factory enabling the tolerances of the same parts to be connected to be controlled with a greater degree of accuracy, as well as to make it easier and convenient for the connection members to be fitted on and the fastening members to be tightened.

According to the present invention, these aims, along with further ones hat shall become more readily apparent in the following description, are reached in a metal cabinet built upon a structural framework comprised of profile-section bar members, whose extremities are connected to each other in a releasable manner by means of connection members and screw-type fastening means, said cabinet incorporating such features and characteristics as recited in the appended claim 1. Further features and aspects of the present invention are defined in the appended sub-claims.

Features and advantages of the present invention will anyway be more readily understood from the description that is given below by way of non-limiting example with reference to the accompanying drawings, in which:
- Figure 1 is a perspective exploded view of a metal cabinet according to the present invention;
- Figures 2 and 3 are perspective exploded views from inside and outside, respectively, of a detail of the structure of the metal cabinet shown in Figure 1;
- Figures 4A and 4B are perspective front and rear views, respectively, of a component part of the structure of the metal cabinet shown in Figure 1; and
- Figures 5A and 5B are perspective front and rear views, respectively, of another component part of the structure of the metal cabinet shown in Figure 1.

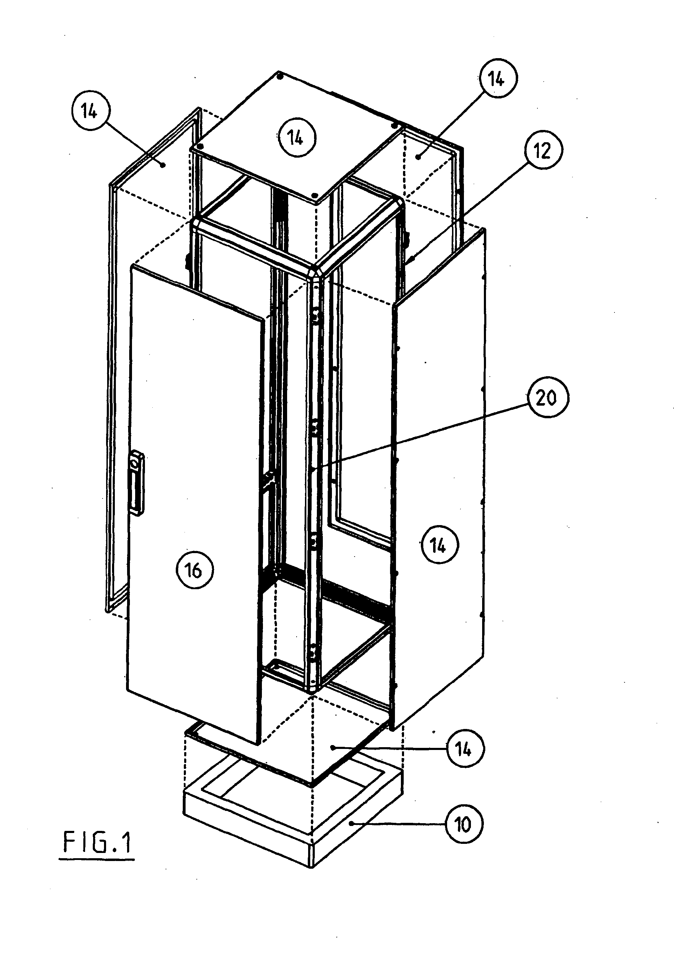

A metal cabinet according to the present invention is usually made to rest upon a base or socle 10 (Figure 1) and is substantially comprised of a structural framework 12, covering panels 14, and at least one closing door 16. In particular, the covering panels 14 are applied to the framework 12 on the side surfaces, the rear surface, the top surface and the bottom surface thereof, whereas the closing door 16 is mounted to close the front aperture of the cabinet. The covering panels and the closing door are mounted to the framework with the aid of connection and fastening means that are largely known as such in the art, such as screws and hinges.

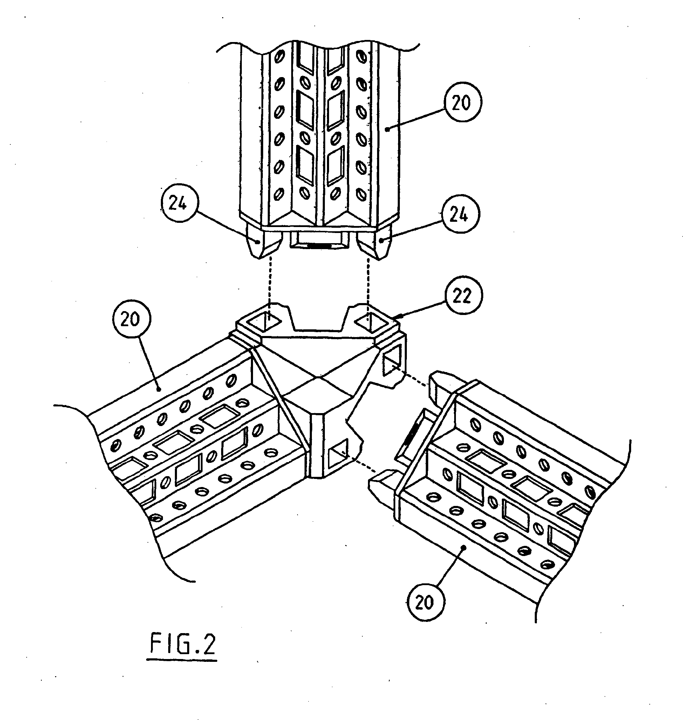

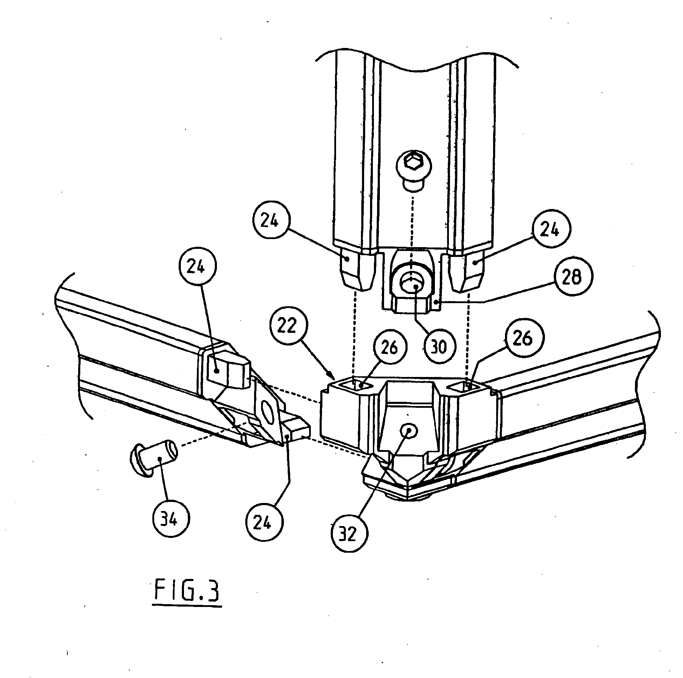

According to the present invention, the structural framework 12 is comprised of rectilinear, hollow profile bars 20 having a polygonal closed cross-section (Figures 2 and 3). The outward facing sides of the profile bars 20 are free of apertures, whereas the inward facing sides thereof are provided with regularly spaced bores drilled at equal intervals along the entire extension of each profile-section bar, so as to enable the support members, as required to accommodate electrical or similar apparatus therewithin, to be applied. The profile-section bars 20 extend vertically and horizontally, respectively, and are connected with each other by means of connection angle members 22. It can of course be readily appreciated that the framework 12 may be extended spatially in a modular form through the simple addition of corresponding profile-section bars 20 and related connection members 22. Similarly, it can be most readily appreciated that, when the overall size of the metal cabinet is in this way increased, there may be mounted a larger number of mutually independent doors to close separate compartments of the same cabinet.

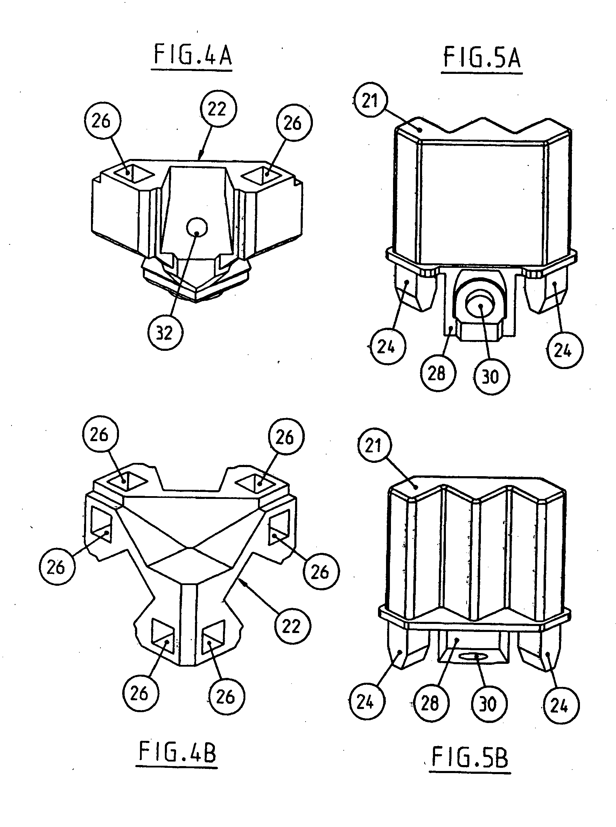

According to an important aspect of the present invention, to the extremity of each profile-section bar 20 of the framework 12 there is attached a terminal member 21 (Figures 5A and 5B) that is provided with at least a properly shaped pin 24 extending in a direction parallel to the axis of the profile-section bar and - as this shall be explained further on - adapted to fit into a corresponding receptacle 26 of a connection angle member 22 (Figures 4A, 4b). The attachment terminal member 21 is firmly joined to the corresponding extremity of the profile-section bar 20 with the aid of any proper means as generally known as such in the art, in particular by means of a seam-folding or similar technique. Moreover, each attachment terminal member 21 is provided with a projecting portion 28, in which there is provided a through-bore 30 that is adapted to cooperate with a threaded receptacle 32 provided in the corresponding connection angle member 22. A screw 34 is fitted into each such through-bore 30 and the respective threaded receptacle 32, which are arranged co-axially, so as to firmly join the profile-section bar 20 and the connection angle member 22 with each other through the attachment terminal member 21.

It can of course be again most readily appreciated that the above-described construction solution may be embodied in a technically equivalent manner if the pins or plugs 24 are provided on the connection angle members 22 and the respective receptacles 26 are on the contrary provided in the attachment terminal members 21.

Advantageously, the pins 24 and the corresponding receptacles 26 have a polygonal, preferably square cross-sectional shape, so as to ensure a more accurate, firm and secure connection.

Both the through-bore 30 in the projecting portion 28 of the attachment terminal member 21 and the threaded receptacle 32 in the connection angle member 22 have an axis that is inclined relative to the longitudinal axis of the profile-section bars 20 that are due to be connected with each other. Such connection geometry makes it much easier and convenient for the fastening screws 34 to be accessed to, while the screw tightening force is applied obliquely, i.e. in a direction that is inclined relative to the axis of the profile-section bar. The screw tightening force, therefore, breaks down into two distinct force components, i.e. a horizontal one and a vertical one, thereby causing the profile-section bar 20 to become firmly fastened to the related connection angle member 22 according to both horizontal and vertical axes. Such result is obtained with the use of a single screw 34, with the advantage that the number of screws needed to complete such connection is cut by half, thereby achieving the main object of the present invention.

The method for manufacturing metal cabinets according to the present invention enables a further advantage to be obtained, in that it makes it possible for two mutually clashing requirements to be additionally complied with. The first one of such mutually clashing requirements calls for making it easier and certainly more convenient for the user to assemble the profile-section bars 20 and the related connection angle members 22 in view of building the structural framework 12 of the cabinet. The second requirement calls for a most stable and firm connection of the various parts forming the framework to be anyway ensured. In this connection, the technical solution described above is such as to enable a profile-section bar 20 and an attachment terminal member 21 to be preassembled prior to the related connection angle member 22 being fitted on and the screw fastening means 34 being tightened. Such pre-assembly is carried out at the factory, so that - when the metal cabinet has eventually to be assembled at the installation site thereof - the user can set up the whole structure by simply fitting the various parts together to finally ensure the stability and strength of the same structure by simply tightening the related screws.

## Claims

1. Metal cabinet, in particular adapted to accommodate and hold electrical and similar apparatus, of the type comprised of a structural framework (12) and covering panels (14), as well as at least one closing door (16), the structural framework being in turn comprised of profile-section bar members (20), the extremities of which are releasably connected to each other by means of connection angle members (22) and screw members (34), said screw members being mounted with their axes inclined relative to the longitudinal axes of the respective profile-section bar members, **characterized in that**:
a) the profile-section bar members (20) forming the framework are hollow and have a closed polygonal cross-sectional shape;
b) to each extremity of said profile-section bar members (20) forming the framework there is attached a terminal fitting (21), which is adapted to cooperate with a corresponding connection angle member (22);
c) said terminal fittings (21) and said connection angle members (22) are mutually associable by means of pins (24) adapted to fit into corresponding receptacles (26).

2. Metal cabinet according to claim 1, **characterized in that**:
- each terminal fitting (21) is provided with at least one pin (24) and a receptacle (30) adapted to receive a screw member (34), and each connection angle member (22) is provided with a plurality of receptacles (26) adapted to receive and accommodate the corresponding pins (24) of the terminal fittings (21) to be connected, as well as a plurality of threaded receptacles (32) corresponding to respective ones of the receptacles (30) provided in the terminal fittings (21) of the profile-section bar members (20) of the framework, for the screw members (34) to be able to be fitted and tightened in.

3. Metal cabinet according to claim 1, **characterized in that** the pins (24) of each terminal fitting (21) extend in a direction that is parallel to the longitudinal axis of the respective profile-section bar member (20), wherein the receptacle (30) is provided in a projecting portion (28) of the terminal fitting (21) and the axis thereof is inclined relative to the longitudinal axis of the profile-section bar members to be connected.

4. Metal cabinet according to claim 2, **characterized in that** the pins (24) and the receptacles (30) are polygonal in their cross-sectional shape.

## Patentansprüche

1. Metallschrank, der insbesondere zum Aufnehmen und Halten elektrischer und ähnlicher Vorrichtungen eingerichtet und von dem Typ ist, der einen strukturellen Rahmen (12) und Abdeckplatten (14) sowie wenigstens eine Verschlusstür (16) umfasst, wobei der strukturelle Rahmen seinerseits aus Profilstabelementen (20) besteht, deren äußere Enden mittels Verbindungswinkelelementen (22) und Schraubenelementen (34) lösbar miteinander verbunden sind, und die Schraubenelemente so angebracht sind, dass ihre Achsen relativ zu den Längsachsen der jeweiligen Profilstabelemente geneigt sind, **dadurch gekennzeichnet, dass**:
a) die Profilstabelemente (20), die den Rahmen bilden, hohl sind und eine geschlossene mehreckige Querschnittsform haben;
b) an jedem äußeren Ende der Profilstabelemente (20), die den Rahmen bilden, ein Abschluss-Passstück (21) angebracht ist, das so eingerichtet ist, dass es mit einem entsprechenden Verbindungswinkelelement (22) zusammenwirkt;
c) die Abschluss-Passstücke (21) und die Verbindungswinkelelemente (22) mittels Stiften (24) miteinander verbunden werden können, die so eingerichtet sind, dass sie in entsprechende Aufnahmen (26) passen.

2. Metallschrank nach Anspruch 1, **dadurch gekennzeichnet, dass**:
jedes Abschluss-Passstück (21) mit wenigstens einem Stift (24) und einer Aufnahme (30) versehen ist, die zum Empfangen eines Schraubenelementes (34) eingerichtet ist, und jedes Verbindungswinkelelement (22) mit einer Vielzahl von Aufnahmen (26) versehen ist, die zum Empfangen und Aufnehmen der entsprechenden Stifte (24) der zu verbindenden Abschluss-Passstücke eingerichtet sind, sowie mit einer Vielzahl mit Gewinde versehener Aufnahmen (32), die jeweiligen der Aufnahmen (30) entsprechen, die in den Abschluss-Passstücken (21) der Profilstabelemente (20) des Rahmens vorhanden sind, so dass die Schraubenelemente (34) darin eingepasst und sie angezogen werden können.

3. Metallschrank nach Anspruch 1, **dadurch gekennzeichnet, dass** sich die Stifte (24) jedes Abschluss-Passteils (21) in einer Richtung erstrecken, die parallel zu der Längsachse des jeweiligen Profilstabelementes (20) ist, wobei die Aufnahme (30) in einem vorstehenden Abschnitt (28) des Abschluss-Passstücks (21) vorhanden ist und die Achse derselben relativ zu der Langsachse der zu verbindenden Profilstabelemente geneigt ist.

4. Metallschrank nach Anspruch 2, **dadurch gekennzeichnet, dass** die Stifte (24) und die Aufnahmen (30) in ihrer Querschnittsform vieleckig sind.

## Revendications

1. Armoire métallique, adaptée en particulier pour loger et maintenir de l'appareillage électrique et similaire, du type comprenant une armature de structure (12) et des panneaux de recouvrement (14), ainsi qu'au moins une porte de fermeture (16), l'armature de structure étant à son tour composée d'éléments de barre à section profilée (20), dont les extrémités sont reliées, de manière à pouvoir être libérées, les unes aux autres au moyen d'éléments angulaire de connexion (22) et d'éléments à vis (34), lesdits éléments à vis étant montés avec leurs axes inclinés par rapport aux axes longitudinaux des éléments de barre à section profilée respectifs, **caractérisée en ce que** :
a) les éléments de barre à section profilée (20) formant l'armature sont creux et ont une forme en section transversale polygonale fermée ;
b) à chaque extrémité desdits éléments de barre à section profilée (20) formant l'armature, est attachée une pièce de fixation terminale (21), qui est adaptée pour coopérer avec un élément angulaire de connexion correspondant (22) ;
c) les dites pièces de fixation terminales (21) et les dits éléments angulaires de connexion (22) peuvent être mutuellement associés au moyen d'ergots (24) adaptés pour s'ajuster dans des réceptacles correspondants (26).

2. Armoire métallique selon la revendication 1, **caractérisée en ce que** :
- chaque pièce de fixation terminale (21) est équipée d'au moins un ergot (24) et d'un réceptacle (30) adapté pour recevoir un élément à vis (34), et chaque élément angulaire de connexion (22) est équipé d'une pluralité de réceptacles (26) adaptés pour recevoir et loger les ergots correspondants (24) des pièces de fixation terminales (21) à connecter, ainsi qu'une pluralité de réceptacles filetés (32) correspondants à des réceptacles respectifs parmi les réceptacles (30) fournis dans les pièces de fixation terminales (21) des éléments de barre à section profilée (20) de l'armature, pour que les éléments à vis (34) puissent être ajustés et serrés dedans.

3. Armoire métallique selon la revendication 1, **caractérisée en ce que** les ergots (24) de chaque pièce de fixation terminale (21) s'étendent dans une direction qui est parallèle à l'axe longitudinal de l'élément de barre à section profilée (20) respectif, le réceptacle (30) étant fourni dans une portion se projetant (28) de la pièce de fixation terminale (21) et l'axe de celui-ci est incliné par rapport à l'axe longitudinal des éléments de barre à section profilée à connecter.

4. Armoire métallique selon la revendication 2, **caractérisée en ce que** les ergots (24) et les réceptacles (30) sont polygonaux dans leur forme en section transversale.
